# EUROPÄISCHE PATENTSCHRIFT

(11) **EP 0 824 790 B1**
(45) Veröffentlichungstag und Bekanntmachung des Hinweises auf die Patenterteilung: **24.07.2002**
(21) Anmeldenummer: 96914153.0
(22) Anmeldetag: 30.04.1996
(51) Int. Cl.: H03K 17/041

(54) **ANSTEUERSCHALTUNG FÜR FELDEFFEKTTRANSISTOREN**
FIELD EFFECT TRANSISTOR DRIVING CIRCUIT
CIRCUIT D'EXCITATION DE TRANSISTORS A EFFET DE CHAMP

(30) Priorität: 03.05.1995 DE 19516138
(43) Veröffentlichungstag der Anmeldung: 25.02.1998
(73) Patentinhaber: TELDIX GmbH, 69123 Heidelberg (DE)
(72) Erfinder: EIFFERT, Karl-Ludwig, D-69198 Schriesheim (DE); ECKARDT, Thomas, D-69123 Heidelberg (DE)
(74) Vertreter: Müller, Frithjof E., Dipl.-Ing.
(86) Internationale Anmeldenummer: EP9601796
(87) Internationale Veröffentlichungsnummer: WO9635260

(56) Entgegenhaltungen:
- EP-A- 0 534 013
- DE-A- 4 110 633
- US-A- 3 940 633
- US-A- 4 297 594
- US-A- 4 873 460
- US-A- 5 134 320

## Beschreibung

### Stand der Technik

Die Erfindung betrifft eine Ansteuerschaltung für einen Feldeffekttransistor, mit einer Induktivität in einer Steuerleitung zur Strombegrenzung, die den Feldeffekttransistor potentialfrei ansteuern kann.

Aus der DE 41 10 633 A1 ist es bekannt, in der Steuerleiturg eines Feldeffekttransistors zum Zwecke der Strombegrenzung eine Induktivität anzuordnen. Diese Induktivität bildet mit der Kapazität des Feldeffekttransistors einen Schwingkreis. Dadurch kann das Schalten des Feldeffekttransistors mit geringen Leistungsverlusten erfolgen.

Aus der EP-A-0 534 013 ist es bekannt, die Induktivität in der Steuerleitung des Feldeffekttransistors mit einer weiteren Induktivität zu koppeln, über die eine Energierückspeisung möglich ist. Hier ist weiter eine potentialfreie Ansteuerung des Feldeffekttransistors vorgeschlagen, die jedoch mit hohen Verlustleistungen arbeitet.

### Vorteile der Erfindung

Mit den Maßnahmen nach dem Anspruch 1 der Erfindung ist die Verlustleistung auch bei höheren Schaltfrequenzen gering, wobei der Feldeffekttransistor potentialfrei angesteuert wird.

Feldeffekttransistoren haben gegenüber bipolaren Transistoren den Vorteil, im Einschaltzustand nahezu keine Ansteuerleistung zu benötigen. Während eines Umschaltvorgangs jedoch muß zum Umladen der Eingangskapazität und der Millerkapazität ein Strom fließen, der bei steigenden Umschaltfrequenzen dazu führt, daß der Vorteil einer geringen Ansteuerleistung schwindet. Der größte Teil der Verlustleistung fällt dabei in der Regel in einem Gate-Vorwiderstand an, der zur Gate-Strombegrenzung dient.

Durch die Verwendung einer Induktivität in der Steuerleitung des Feldeffekttransistors zur Gate-Strombegrenzung wird beim Umladen der Gate-Kapazität die darin enthaltene Energie zwischengespeichert und dazu benutzt, die Gate-Kapazität mit anderer Polarität zu laden. Die am Gate anliegende Spannung wird durch die weitere Induktivität, deren Wicklungssinn und Beschaltung vorzugsweise so gewählt ist, daß sie als Entladewicklung wirkt, begrenzt. Somit kann über die weitere Induktivität/Entladewicklung die überschüssige Energie vorzugsweise in die Spannungsversorgung der Gate-Ansteuerelektronik für den Feldeffekttransistor zurückgespeist werden.

Mit den Maßnahmen nach dem Anspruch 1 der Erfindung ist weiter die Gate-Ansteuerung potentialfrei mittels Impulsübertragern realisiert, wobei der in der weiteren Induktivität/Entladewicklung fließende Strom zum Steuern bzw. Ausschalten der Impulsübertragungsschaltung dient.

Die Anordnung nach der Erfindung läßt sich vorteilhaft auch in einer Halbbrükkenschaltung verwenden.

### Zeichnungen

Ausführungsbeispiele der Erfindung sind in den Figuren 1 bis 4 dargestellt. Es zeigen
**Figur 1** ein Funktionsbild einer nicht potentialfreien Ansteuerschaltung,
**Figur 2** ein Prinzipschaltbild einer potentialfreien Ansteuerschaltung nach der Erfindung,
**Figur 3** ein Prinzipschaltbild mit Halbbrückensteuerung und zwei Impulsübertragern, und
**Figur 4** ein Prinzipschaltbild gemäß Figur 3 zum gleichzeitigen Ausschalten von zwei ansteuerbaren Feldeffekttransistoren.

### Beschreibung der Erfindung

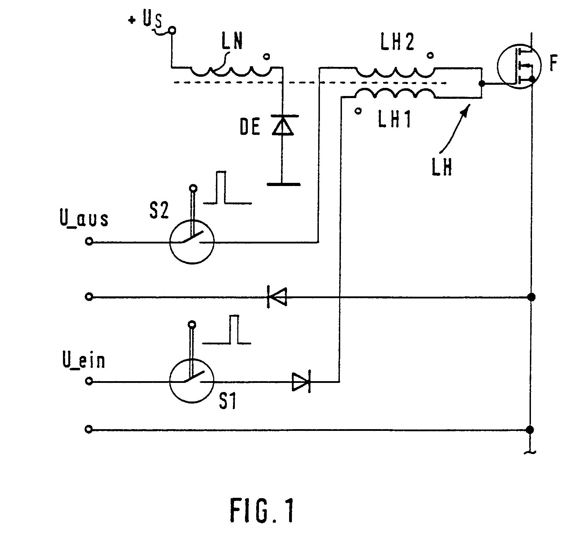

Das Funktionsbild einer herkömmlichen nicht potentialfreien Ansteuerschaltung gemäß Figur 1 zeigt einen anzusteuernden Feldeffekttransistor F - hier als MOS-FET ausgebildet - in dessen Gate-Zuleitung eine Induktivität LH angeordnet ist. Die Induktivität LH ist hier als Impulsübertrager mit den Teilinduktivitäten LH1 und LH2 ausgebildet. Die Leitendsteuerung des Feldeffekttransistors F erfolgt über einen Einschaltimpuls, der dadurch erzeugt wird, daß die Spannung der Stromversorgungsquelle über den Schalter Si und die Teilinduktivität LH1 an das Gate geschaltet wird (symbolisiert durch Uein). Das Ausschalten des Feldeffekttransistors F erfolgt entsprechend über den Schalter S2 und die Teilinduktivität LH2. Die Einschalt- und Ausschaltpulse für den Feldeffekttransistor F sind, wie in Figur 1 schematisch dargestellt, in der Phase gegeneinander versetzt, vorzugsweise um 180 Grad (Gegentaktpulse). Eine weitere Induktivität LN ist mit der Induktivität LH so gekoppelt, daß über diese eine Energierückspeisung, insbesondere während des Umladevorgangs der Gate-Kapazität des Feldeffekttransistors F möglich ist. Für diese Energierückspeisung ist die Induktivität LN mit ihrem Wicklungssinn (in Figur 1 durch Kreise markiert) bezüglich der Wicklungen der Induktivitäten LH1 und LH2 so angeordnet, daß sie als Entladewicklung arbeiten kann. Entsprechend ist auch die in Serie angeordnete Diode DE gepolt. Die am Gate des Feldeffekttransistors F anliegende Spannung wird demnach durch die Energierückspeisung über die Entladewicklung LN begrenzt. Die Energierückspeisung erfolgt vorzugsweise zur Spannungsversorgung - in Figur 1 symbolisiert durch Us - der Gate-Ansteuerelektronik. Eine dieser Ansteuerschaltung ähnliche Ansteuerschaltung ist in der EP-A-0 534 013 offenbart.

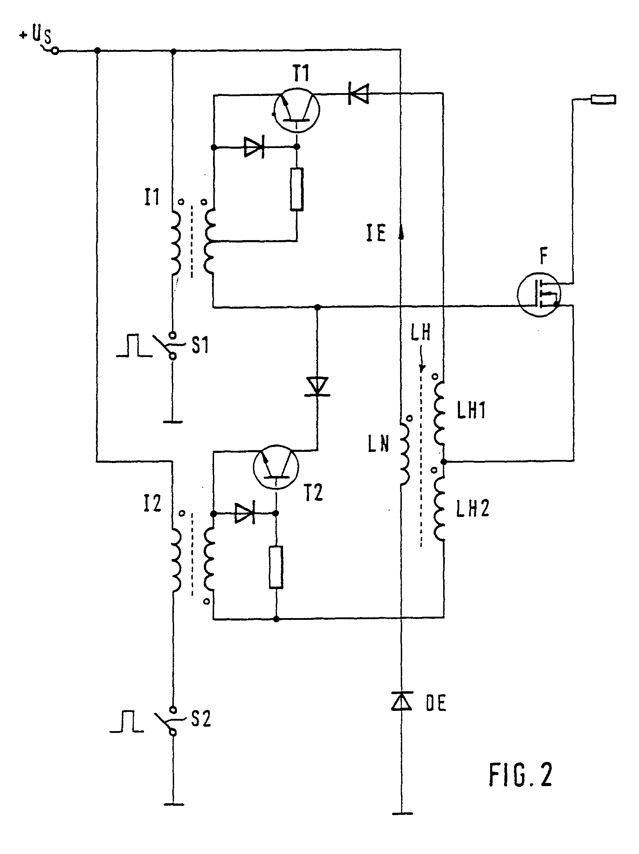

Die Gate-Ansteuerung nach der Erfindung ist potentialfrei mittels Impulsübertragern realisiert. Eine diesbezügliche Ausgestaltung zeigt die Figur 2 mit den Impulsübertragen I1 und I2. Die beiden Schalter S1 und S2 liegen in Serie zu den Primärwicklungen dieser Impulsübertrager jeweils an der Versorgungsspannung Us der Ansteuerelektronik. Die jeweiligen Sekundärwicklungen arbeiten - über die Transistoren T1 und T2 - auf die Induktivitäten LH1 und LH2. Ihre Schaltstrecken stehen über die Induktivitäten LH1 und LH2 in Wirkverbindung zum Gate des Feldeffekttransistors F. Der zum Einschalten des Feldeffekttransistors F dienende Transistor T1 wird über eine Anzapfung der Sekundärwicklung des Impulsübertragers I1 gesteuert. Für den Transistor T2 zum Ausschalten des Feldeffekttransistors F ist eine solche Maßnahme normalerweise entbehrlich, da keine so hohe Spannung zum Ausschalten des Feldeffekttranistors F notwendig ist. Die Teilinduktivität IN dient zur Begrenzung der Gatespannung und zur Rückspeisung überschüssiger Energie. Der Entladestrom kann zum Steuern der Impulsübertragungsschaltung genutzt werden.

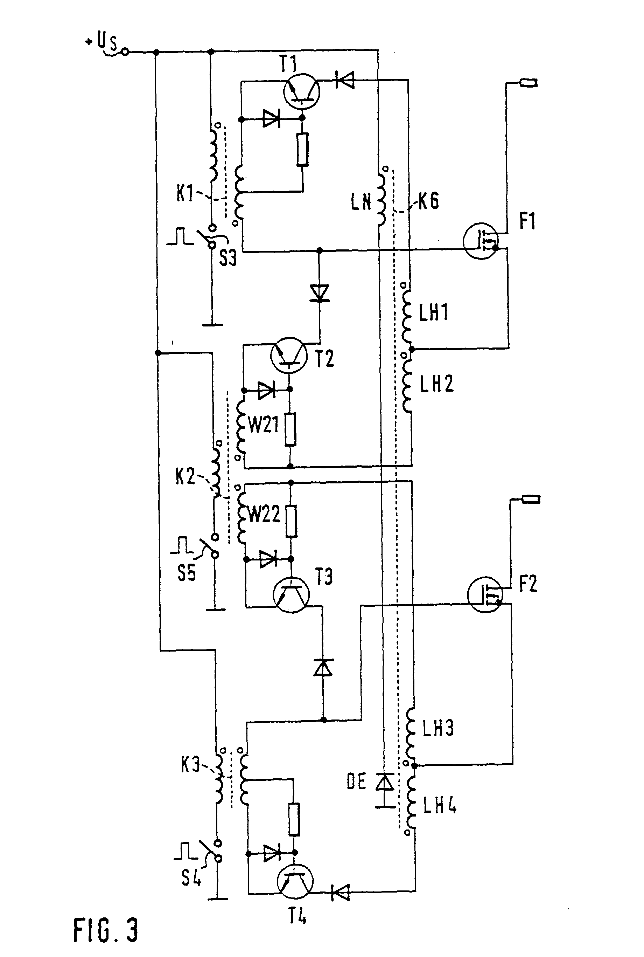

Das Ausführungsbeispiel gemäß Figur 3 zeigt eine Ausgestaltung für die Ansteuerung zweier Feldeffekttransistoren F1 und F2 in Halbbrückenschaltung. Zum Einschalten der Feldeffekttransistoren F1 und F2 sind getrennte Schalter S3 und S4 vorgesehen, wohingegen zum Ausschalten der gemeinsame Schalter SS dient. Entsprechend sind den Schaltern S3 und S4 separate Impulsübertrager mit den Kernen K1 und K3 zugeordnet und dem Schalter S5 ein Impulsübertrager mit dem Kern K2 und zwei Sekundärwicklungen W21 und W22. Die zum Ausschalten der Feldeffekttransistoren F1 und F2 vorgesehenen Transistoren T2 und T3 sind den Sekundärwicklungen W21 und W22 jeweils mit ihren Schaltstrecken in Serie geschaltet. Die Induktivitäten LH1 und LH2 sowie LH3 und LH4 in den Steuerleitungen der Feldeffekttransistoren F1 und F2 besitzen zusammen mit der Entladewicklung LN den gemeinsamen Kern K6.

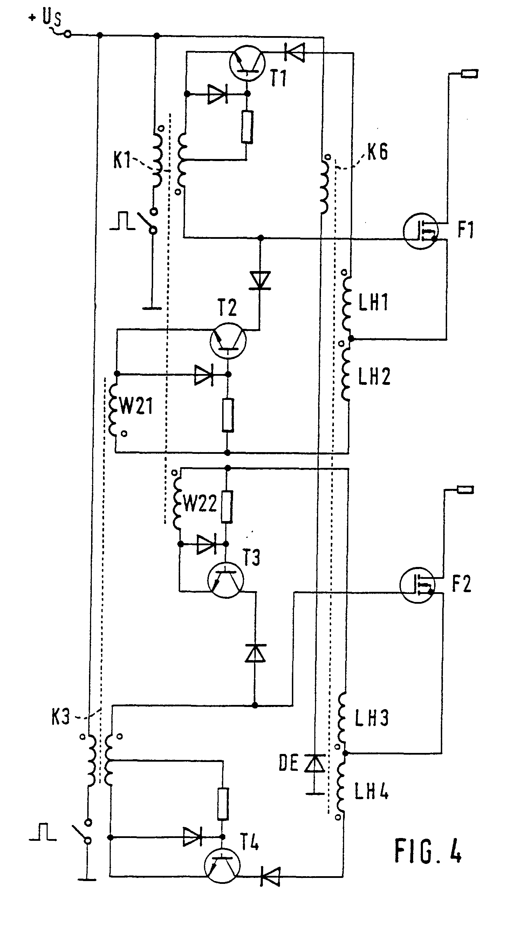

Wenn beide Feldeffekttransistoren FI und F2 gleichzeitig geschaltet werden dürfen, kann der Kern K2, die zugehörige Primärwicklung und der Schalter S5 in Figur 3 entfallen. Diese Ausgestaltung zeigt das Ausführungsbeispiel gemäß Figur 4. Die Sekundärwicklung W21 ist dann auf dem Kern K3 angeordnet und die Sekundärwicklung W22 auf dem Kern K1. Die übrige Beschaltung kann wie in Figur 3 realisiert werden.

## Patentansprüche

1. Ansteuerschaltung für mindestens einen Feldeffekttransistor (F), mit mindestens einer Induktivität (LH) zur Strombegrenzung in einem Gate-Kreislauf des Feldeffekttransistors (F) über die der Feldeffekttransistor (F) mittels von Schaltern (S1, S2) erzeugten Impulsen, die eine zum Schalten des Feldeffekttransistors (F) notwendige Leistung enthalten, leitend bzw. sperrend gesteuert wird, wobei die Induktivität (LH) mit einer weiteren Induktivität (LN) so gekoppelt ist, daß über diese weitere Induktivität (LN) eine Energierückspeisung möglich ist, **dadurch gekennzeichnet, daß** der Gate-Kreislauf aus zwei Serienverbindungen besteht, die jeweils aus den Schaltstrecken eines Transistors (T1, T2), der Sekundärwicklung eines zwischen einen der Schalter (S1, S2) und einen der Transistoren (T1, T2) geschalteten Impulsüberträgers (I1, I2), einer Teilinduktivität (LH1, LH2) der Induktivität (LH) und der Gate-Source Strecke des Feldeffekttransistors (F) bestehen, wobei die Primärwicklungen der Impulsüberträger (11, 12) derart mit den Schaltern (S1, S2) verbunden sind, und die Steuer-Anschlüsse der Transistoren (T1, T2) derart mit den Sekundärwicklungen verbunden sind, daß die Transistoren (T1, T2) mittels der Schalter (S1, S2) im Gegentakt betrieben werden, und wobei die Impulsüberträger (11, 12) die zum Schalten des Feldeffekttransistors (F) notwendige Leistung übertragen.

2. Ansteuerschaltung nach Anspruch 1, **dadurch gekennzeichnet, daß** die weitere Induktivität (LN) bezüglich ihres Wicklungssinnes und ihrer Beschaltung so angeordnet ist, daß die am Gate des Feldeffekttransistors (F) anliegende Spannung begrenzt werden kann.

3. Ansteuerschaltung nach Anspruch 1 oder 2, **dadurch gekennzeichnet, daß** zumindest einer der Impulsübertrager (I1, I2) eine Anzapfung aufweist, wobei der Steuer-Anschluß des zugehörigen Transistors (T1) über diese Anzapfung mit der Sekundärwicklung des Impulsübertragers verbunden ist.

4. Ansteuerschaltung nach einem der Ansprüche 1 bis 3, **dadurch gekennzeichnet, daß** sie für zwei in Halbbrückenschaltung angeordnete Feldeffekttransistoren (F1, F2) ausgelegt ist, wobei diese Feldeffekttransistoren (F1, F2) jeweils paarweise über Transistoren (T1, T2, T3, T4) mit zugehörigen Impulsübertragern (K1, K2, K3) gesteuert werden.

5. Ansteuerschaltung nach Anspruch 4, **dadurch gekennzeichnet, daß** zum Einschalten der Transistoren (T1, T2, T3, T4) jeweils ein separater Impulsübertrager (K1, K3) vorgesehen ist und daß zum Ausschalten ein gemeinsamer Impulsübertrager (K2) vorgesehen ist.

6. Ansteuerschaltung nach Anspruch 4, **dadurch gekennzeichnet, daß** für das Ein- und Ausschalten der Transistoren (T1, T2, T3, T4) insgesamt nur zwei Impulsübertrager (K1, K3) vorgesehen sind, deren Sekundärwicklungen jeweils auf ein Transistorpaar (T1, T2; T3, T4) arbeiten.

## Claims

1. A driving circuit for at least one field effect transistor (F) having at least one inductance (LH) for current limiting in a gate circuit of the field effect transistor (F) by means of which the field effect transistor (F), through pulses which are produced by switches (S1, S2) and comprise the necessary capacity for switching the field effect transistor, is controlled so as to conduct or to block, whereby the inductance (LH) is coupled to an additional inductance (LN) in such a way that, by means of this additional inductance (LN), an energy recovery feed is possible, **characterised in that** the gate circuit consists of two series connections which in each case consist of the switching paths of a transistor (T1, T2), the secondary winding of a pulse transformer (I1, I2) connected between one of the switches (S1, S2) and one of the transistors (T1, T2), a sub-inductance (LH1, LH2) of the inductance (LH) and the gate source path of the field effect transistor (F), whereby the primary windings of the pulse transformers (I1, I2) are connected in such a way with the switches (S1, S2) and the control connectors of the transistors (T1, T2) are connected in such a way with the secondary windings that the transistors (T1, T2) are operated in push-pull manner by means of the switches (S1, S2), and whereby the pulse transformers (I1, I2) carry the necessary capacity for switching the field effect transistor (F).

2. A driving circuit according to claim 1, **characterised in that** the additional inductance (LN) is arranged, in respect of its direction of winding and of its switching, in such a way that the voltage applied at the gate of the field effect transistor (F) can be limited.

3. A driving circuit according to claim 1 or 2, **characterised in that** at least one of the pulse transformers (I1, I2) comprises a tapping, whereby the control connector of the associated transistor (T1) is connected to the secondary winding of the pulse transformer by means of said tapping.

4. A driving circuit according to one of the claims 1 to 3, **characterised in that** it is designed for two field effect transistors (F1, F2) arranged in half-bridge connection, whereby said field effect transistors (F1, F2) in each case are controlled by means of transistors (T1, T2, T3, T4), in pairs, with associated pulse transformers (K1, K2, K3).

5. A driving circuit according to claim 4, **characterised in that**, for the turn-on of the transistors (T1, T2, T3, T4), in each case a separate pulse transformer (K1, K3) is provided and that, for the turn-off, a common pulse transformer (K2) is provided.

6. A driving circuit according to claim 4, **characterised in that**, for the turn-on and the turn-off of the transistors (T1, T2, T3, T4), altogether only two pulse transformers (K1, K3) are provided the secondary windings of which in each case act upon one pair of transistors (T1, T2; T3, T4).

## Revendications

1. Circuit d'excitation pour au moins un transistor à effet de champ (F), avec au moins une inductance (LH) pour limiter le courant dans un circuit de grille dudit transistor (F), par l'intermédiaire de laquelle celui-ci est commandé pour être rendu conducteur ou non conducteur à l'aide d'impulsions qui sont générées par des commutateurs (S1, S2) et qui contiennent une puissance nécessaire pour commuter le transistor (F), l'inductance (LH) étant couplée à une autre inductance (LN) de telle sorte qu'un retour d'énergie soit possible par l'intermédiaire de cette autre inductance (LN), **caractérisé en ce que** le circuit de grille est formé de deux liaisons en série qui se composent chacune des longueurs de coupure d'un transistor (T1, T2), de l'enroulement secondaire d'un transformateur d'impulsions (I1, I2) monté entre l'un des commutateurs (S1, S2) et l'un des transistors (T1, T2), d'une inductance partielle (LH1, LH2) de l'inductance (LH) et de la distance grille-source du transistor à effet de champ (F), les enroulements primaires des transformateurs d'impulsions (I1, I2) étant reliés aux commutateurs (S1, S2) et les raccordements de commande des transistors (T1, T2) étant reliés aux enroulements secondaires de telle sorte que les transistors (T1, T2) fonctionnent en push-pull à l'aide des commutateurs (S1, S2), et les transformateurs d'impulsions (I1, I2) transmettant la puissance nécessaire pour commuter le transistor à effet de champ (F).

2. Circuit d'excitation selon la revendication 1, **caractérisé en ce que** l'autre inductance (LN) est disposée, en ce qui concerne son sens d'enroulement et son câblage, de telle sorte que la tension appliquée au niveau de la grille du transistor à effet de champ (F) puisse être limitée.

3. Circuit d'excitation selon la revendication 1 ou 2, **caractérisé en ce que** l'un au moins des transformateurs d'impulsions (I1, I2) a une prise, le raccordement de commande du transistor associé (T1) étant relié par l'intermédiaire de cette prise à l'enroulement secondaire du transformateur d'impulsions.

4. Circuit de commande selon l'une des revendications 1 à 3, **caractérisé en ce qu'**il est conçu pour deux transistors à effet de champ (F1, F2) disposés suivant un montage en demi-pont, ces transistors à effet de champ (F1, F2) étant commandés par paires par l'intermédiaire de transistors (T1, T2, T3, T4) avec des transformateurs d'impulsions associés (K1, K2, K3).

5. Circuit de commande selon la revendication 4, **caractérisé en ce qu'**il est prévu un transformateur d'impulsions distinct (K1, K3) pour mettre en circuit les transistors (T1, T2, T3, T4), et **en ce qu'**il est prévu un transformateur d'impulsions commun (K2) pour la mise hors circuit.

6. Circuit de commande selon la revendication 4, **caractérisé en ce que** pour la mise en circuit et la mise hors circuit des transistors (T1, T2, T3, T4), il n'est prévu en tout que deux transformateurs d'impulsions (K1, K3) dont les enroulements secondaires fonctionnent chacun sur une paire de transistors (T1, T2 ; T3, T4).
